# EUROPÄISCHE PATENTSCHRIFT

(11) **EP 0 743 756 B1**
(45) Veröffentlichungstag und Bekanntmachung des Hinweises auf die Patenterteilung: **13.08.1997**
(21) Anmeldenummer: 95106850.1
(22) Anmeldetag: 05.05.1995
(51) Int. Cl.: H03K 19/173

(54) **Konfigurierbare integrierte Schaltung**
Configurable integrated circuit
Circuit intégré configurable

(43) Veröffentlichungstag der Anmeldung: 20.11.1996
(73) Patentinhaber: SIEMENS AKTIENGESELLSCHAFT, 80333 München (DE)
(72) Erfinder: Johnson, Bret A., D-81737 München (DE)

(56) Entgegenhaltungen:
- EP-A- 0 342 590
- EP-A- 0 570 158
- US-A- 4 556 806
- US-A- 5 051 622

## Beschreibung

Die Erfindung betrifft eine konfigurierbare integrierte Schaltung mit Kontaktierungsstellen, die über Bonddrähte mit externen Anschlüssen der integrierten Schaltung verbindbar sind.

Derartige Kontaktierungsstellen werden im allgemeinen als "Bond Pads" bezeichnet. Sie müssen ausreichende Abmessungen aufweisen, damit die Bonddrähte auf ihnen befestigt werden können. Im Layout einer integrierten Schaltung nehmen die Kontaktierungsstellen daher einen nennenswerten Teil der zur Verfügung stehenden Fläche ein. Aus EP-A-0 570 158 ist es bekannt, die Programmierung eines Taktsignalgenerators durch Bonding einer Kontaktierungsstelle mit alternativen Versorgungsanschlüssen durch zuführen.

Um integrierte Schaltungen zu konfigurieren, d.h. in unterschiedliche Betriebszustände zu versetzen, ist es bekannt, Konfigurationssignale zu verwenden. Ein solches Konfigurationssignal ist mit Hilfe eines Konfigurationssignal-Generators erzeugbar, dessen Ausgangssignal durch das Potential an seinem Eingang bestimmt wird, vgl. US-A-5 051 622.

Der Erfindung liegt die Aufgabe zugrunde, eine konfigurierbare integrierte Schaltung zu schaffen, die einen geringen Platzbedarf hat.

Diese Aufgabe wird durch eine konfigurierbare integrierte Schaltung gemäß Anspruch 1 sowie durch das Herstellungs verfahren gemäß Anspruch 14 gelöst.

Die erfindungsgemäße integrierte Schaltung erlaubt die Herstellung zweier Varianten einer integrierten Schaltung aus demselben Layout und mit denselben Masken, wobei bei der ersten Variante der Konfigurationssignal-Generator nutzbar ist und bei der zweiten Variante die Pufferschaltung nutzbar ist, jedoch bei keiner Variante beide nutzbar sind. Zur Herstellung der ersten Variante wird die gemeinsame Kontaktierungsstelle durch einen Bond-Draht mit dem Versorgungspotentialanschluß verbunden, zur Herstellung der zweiten Variante dagegen mit dem Datenanschluß. Auf diese Weise ist es möglich, erst am Ende des Herstellungsprozesses der integrierten Schaltung durch die Art des Bondings der Kontaktierungsstelle festzulegen, welche Variante hergestellt wird.

Die integrierte Schaltung weist weniger Kontaktierungsstellen als vergleichbare Schaltungen auf, weil für den Konfigurationssignal-Generator und die Pufferschaltung nur eine einzige gemeinsame Kontaktierungsstelle notwendig ist. Sie ist daher mit geringerem Platzaufwand herstellbar.

Insbesondere eignet sich die Erfindung daher zur nachträglichen Veränderung eines bereits bestehenden Layouts einer integrierten Schaltung, da dann in der Regel kaum noch freier Platz zur Unterbringung zusätzlicher Komponenenten zur Verfügung steht. In diesem Fall ist zur alternativen Nutzung eines zusätzlichen Konfigurationssignal-Generators oder einer zusätzlichen Pufferschaltung nur eine gemeinsame zusätzliche Kontaktierungsstelle notwendig anstelle von zwei Kontaktierungsstellen.

Ist in einem anderen Fall beispielsweise bereits ein Kontaktierungssignal-Generator vorhanden, welcher in einer ersten Variante der integrierten Schaltung nutzbar sein soll, und für die zweite Variante soll alternativ eine zusätzliche Pufferschaltung nutzbar sein, muß lediglich die Pufferschaltung ergänzt werden. Eine zusätzliche Kontaktierungsstelle ist dann überhaupt nicht erforderlich. Entsprechendes gilt, wenn eine Pufferschaltung bereits vorhanden ist und ein alternativ nutzbarer Konfigurationssignal-Generator ergänzt werden soll.

Sind mehrere Konfigurationssignal-Generatoren und Pufferschaltungen vorhanden, sind durch die Verwendung gemeinsamer Kontaktierungsstellen für mindestens je einen Konfigurationssignal-Generator und eine Pufferschaltung mehr als zwei Varianten der integrierten Schaltung herstellbar.

Ausführungsformen der Erfindung sind in den abhängigen Ansprüchen gekennzeichnet.

Ist der Konfigurationssignal-Generator aktivierbar und deaktivierbar, kann er, wenn die zweite Variante der integrierten Schaltung hergestellt wurde, inaktiv geschaltet werden, denn das Konfigurationssignal wird dann nicht benötigt. Dies bietet den Vorteil, daß die an ihn angeschlossenen weiteren Schaltungselemente der integrierten Schaltung nicht durch andernfalls auftretende Änderungen des Konfigurationssignals beeinflußt werden. Entsprechendes gilt, wenn die Pufferschaltung aktivierbar und deaktivierbar ist, für die erste Variante der integrierten Schaltung und die der Pufferschaltung nachgeschalteten Schaltungskomponenten.

Es ist möglich, daß dieselbe Kontaktierungsstelle mit einem weiteren Versorgungspotentialanschluß der integrierten Schaltung verbindbar ist. Für die Nutzung des Konfigurationssignal-Generators ist dieser dann über dieselbe Kontaktierungsstelle wahlweise mit dem Versorgungspotentialanschluß (z.B. VDD) oder dem weiteren Versorgungspotentialanschluß (z.B. VSS) verbindbar. Der Zustand des Konfigurationssignals ist dabei abhängig davon, mit welchem der Versorgungspotentialanschlüsse die Kontaktierungsstelle verbunden wird. Der Zustand des Konfigurationssignals kann mit dem jeweiligen Versorgungspotential übereinstimmen.

Die Erfindung wird im folgenden anhand der Zeichnung erläutert. Es zeigen:
- Figuren 1 und 2: Ausführungsbeispiele der Erfindung,
- Figuren 3 und 5: Ausführungsbeispiele eines Konfigurationssignal-Generators,
- Figur 4: ein Ausführungsbeispiel einer ersten Aktivierungseinrichtung,
- Figur 6: ein Ausführungsbeispiel einer Eingangspufferschaltung,

In den Figuren sind nur die für die Erfindung wichtigen Komponenten dargestellt.

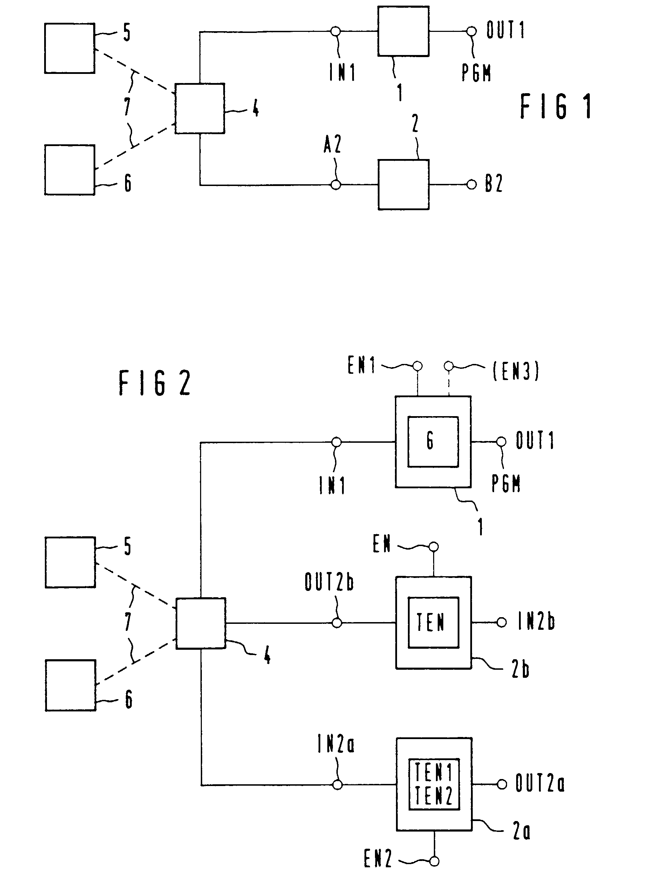

Figur 1 zeigt eine Kontaktierungsstelle (Bond Pad) 4 einer integrierten Schaltung, welche über Bonddrähte 7 mit einem Datenanschluß 5 und mit einem Versorgungspotentialanschluß 6, welche externe Anschlüsse 5, 6 der integrierten Schaltung sind, verbindbar ist. Die Kontaktierungsstelle 4 ist mit einem Eingang IN1 eines Konfigurationssignal-Generators 1 und einem Anschluß A2 einer Pufferschaltung 2 verbunden. Es wurde dabei auf die Darstellung von üblicherweise vorhandenen, aber für die Erfindung nicht relevanten ESD-Schutzschaltungen verzichtet. Ein weiterer Anschluß B2 der Pufferschaltung 2 und ein Ausgang OUT1 des Konfigurationssignal-Generators 1 sind mit anderen, nicht dargestellten Schaltungskomponenten der integrierten Schaltung verbunden.

Es wird nun angenommen, daß bei einer ersten Variante der integrierten Schaltung der Konfigurationssignal-Generator 1 benötigt wird, während bei einer anderen, zweiten Variante die Pufferschaltung 2 benötigt wird. Zur Inbetriebnahme des Konfigurationssignal-Generators 1 (erste Variante) wird die Kontaktierungsstelle 4 entweder mit keinem der externen Anschlüsse 5, 6 oder mit dem Versorgungspotentialanschluß 6 verbunden. Zur Inbetriebnahme der Pufferschaltung 2 (zweite Variante) wird die Kontaktierungsstelle 4 über einen Bond-draht 7 mit dem Datenanschluß 5 verbunden. Es ist nun möglich, mit demselben Layout eine konfigurierbare integrierte Schaltung herzustellen, bei der erst durch das den Herstellungsprozeß abschließende Bonding festgelegt wird, welche Variante dieser integrierten Schaltung hergestellt wird.

Je nachdem, ob der Datenanschluß 5 ein Dateneingang oder ein Datenausgang ist, ist die Pufferschaltung 2 eine Eingangspufferschaltung 2a oder eine Ausgangspufferschaltung 2b.

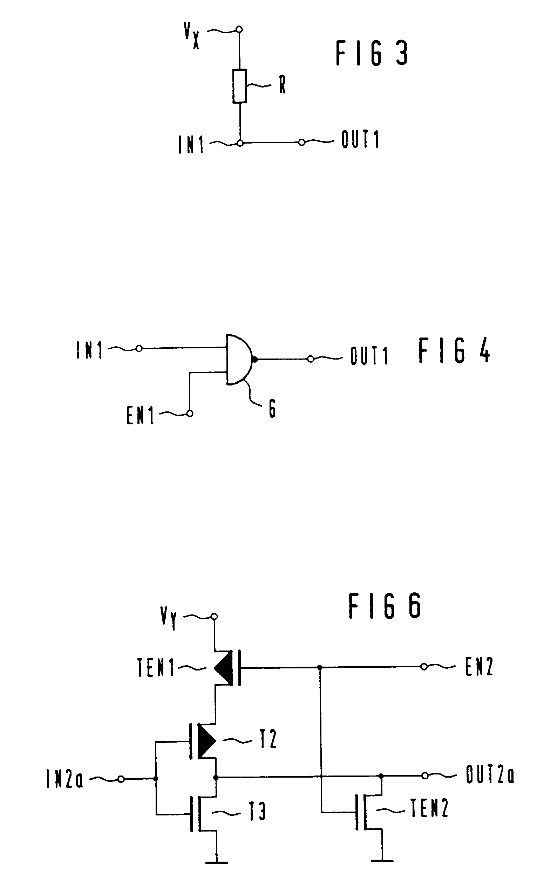

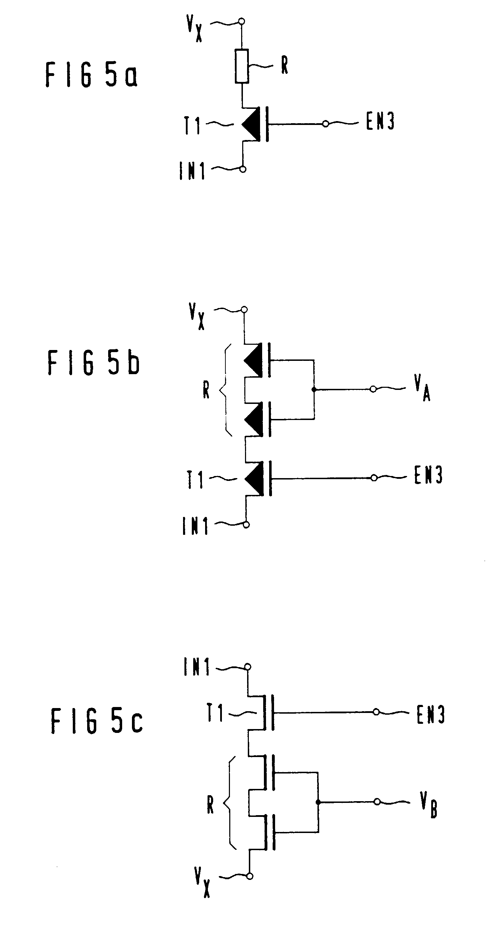

Der Konfigurationssignal-Generator 1 erzeugt an seinem Ausgang OUT1 in Abhängigkeit eines Potentials an seinem Eingang IN1 ein Konfigurationssignal PGM, welches zwei verschiedene Potentialwerte annehmen kann. Das Konfigurationssignal PGM weist einen ersten Potentialwert auf, wenn die Kontaktierungsstelle 4 nicht gebonded ist. Es weist einen zweiten Potentialwert auf, wenn die Kontaktierungsstelle 4 mit dem Versorgungspotentialanschluß 6 verbunden ist. Ausführungsformen des Konfigurationssignal-Generators 1 sind in den Figuren 3 und 5 dargestellt und werden weiter unten erläutert.

Figur 2 zeigt ein anderes Ausführungsbeispiel der Erfindung, bei dem außer dem Eingang IN1 des Konfigurationssignal-Generators 1 ein Eingang IN2a einer Eingangspufferschaltung 2a und ein Ausgang OUT2b einer Ausgangspufferschaltung 2b mit derselben Kontaktierungsstelle 4 verbunden sind. Die Ausgangspufferschaltung 2b hat die Funktion eines Ausgangstreibers. Hier ist neben einer Variante der integrierten Schaltung, bei welcher der Konfigurationssignal-Generator 1 benutzt wird, eine Variante realisierbar, bei welcher stattdessen der Datenanschluß 5 als ein zusätzlicher Datenein- und -ausgang nutzbar ist.

Der Konfigurationssignal-Generator 1 weist eine erste Aktivierungseinrichtung G auf, an die ein erstes Aktivierungssignal EN1 zu seiner Aktivierung anlegbar ist. Figur 4 zeigt eine mögliche Ausführungsform des Konfigurationssignal-Generators 1 mit der ersten Aktivierungseinrichtung G. Darüberhinaus kann an den Konfigurationssignal-Generator 1 ein drittes Aktivierungssignal EN3 anlegbar sein, dessen Funktion weiter unten anhand Figur 5 erläutert wird.

Die Eingangspufferschaltung 2a in Figur 2 weist zweite Aktivierungseinrichtungen TEN1, TEN2 auf, die über ein anlegbares zweites Aktivierungssignal EN2 steuerbar sind. Ein Ausführungsbeispiel für die zweiten Aktivierungseinrichtungen TEN1, TEN2 wird weiter unten anhand der Figur 6 erläutert.

Mit dem ersten EN1 und dem zweiten EN2 Aktivierungssignal (Figur 2) ist erreichbar, daß bei der Variante der integrierten Schaltung, bei welcher der Konfigurationssignal-Generator 1 nutzbar ist, dieser aktivierbar und die Eingangspufferschaltung 2a inaktivierbar ist. Für die andere Variante gilt dies entsprechend umgekehrt.

Durch die Verwendung der ersten Aktivierungseinrichtung G zum Inaktivieren des Konfigurationssignal-Generators 1 ist verhinderbar, daß sich bei Nutzung der dann über die Kontaktierungsstelle 4 mit dem Datenanschluß 5 verbundenen Eingangspufferschaltung 2a Änderungen des Potentials an der Kontaktierungsstelle 4 auf Schaltungskomponenten der integrierten Schaltung auswirken, welche mit dem Ausgang OUT1 des bei dieser Variante nicht nutzbaren Konfigurationssignal-Generators 1 verbunden sind. Für die zweiten Aktivierungseinrichtungen TEN1, TEN2 gilt entsprechendes bezüglich der Inaktivierung der Eingangspufferschaltung 2a, wenn der Konfigurationssignal-Generator 1 nutzbar ist und die Kontaktierungsstelle 4 entweder gar nicht gebonded oder mit dem Versorgungspotentialanschluß 6 verbunden ist.

Sind der Konfigurationssignal-Generator 1 und die Eingangspufferschaltung 2 durch zueinander komplementäre logische Pegel aktivierbar, kann das erste EN1 mit dem zweiten EN2 Aktivierungssignal übereinstimmen.

Die Ausgangspufferschaltung 2b in Figur 2 weist eine Aktivierungseinrichtung TEN auf. Über diese ist sie mittels eines Aktivierungssignals EN aktivierbar und deaktivierbar. Der Ausgang OUT2b der Ausgangspufferschaltung 2b ist im deaktiven Zustand hochohmig. Bei Nutzung des Konfigurationssignal-Generators 1 kann so eine Beeinflussung des Potentials an der Kontaktierungsstelle 4 durch Störungen am Eingang IN2b der Ausgangspufferschaltung 2b ausgeschlossen werden. Ihr Eingang IN2b ist mit nicht dargestellten Komponenten der integrierten Schaltung verbunden.

Figur 6 zeigt exemplarisch eine mögliche Ausführungsform einer Eingangspufferschaltung 2a. Diese wird weiter unten erläutert. Weitere Realisierungsmöglichkeiten für Pufferschaltungen 2, insbesondere für Ausgangspufferschaltungen 2b, welche die Funktion von Ausgangstreibern haben, sowie für entsprechende Aktivierungseinrichtungen TEN1, TEN2 sind dem Fachmann bekannt und müssen hier daher nicht weiter erläutert werden.

Figur 3 zeigt ein Ausführungsbeispiel für den in Figur 1 dargestellten Konfigurationssignal-Generator 1, der keine Aktivierungseinrichtung G aufweist. Sein Eingang IN1 ist mit seinem Ausgang OUT1 verbunden. Außerdem ist der Eingang IN1 über ein Widerstandselement R mit einem ersten Potential Vx verbunden, welches sich vom Versorgungspotential am Versorgungspotentialanschluß 6 unterscheidet. Das erste Potential Vx kann beispielsweise ein anderes Versorgungspotential der integrierten Schaltung sein.

Das Widerstandselement R kann beispielsweise ein ohmscher Widerstand oder ein als Widerstand verbundener Transistor sein. Das erste Potential Vx kann größer oder kleiner als das Potential am Versorgungspotentialanschluß 6 sein, so daß das Widerstandselement R die Funktion eines Pull-up bzw. Pull-down-Widerstandes übernimmt.

Figur 4 zeigt ein Ausführungsbeispiel der ersten Aktivierungseinrichtung G des in Figur 2 dargestellten Konfigurationssignal-Generators 1. Sie ist hier durch ein NAND-Gatter realisiert. Der Ausgang des Gatters G ist der Ausgang OUT1 des Konfigurationssignal-Generators 1. Ein Eingang des Gatters G ist der Eingang IN1 des Konfigurationssignal-Generators 1. Über einen weiteren Eingang des Gatters G ist das erste Aktivierungssignal EN1 anlegbar. Anstelle eines NAND-Gatters können beispielsweise auch andere Gatter (z.B. NOR) zur Realisierung der ersten Aktivierungseinrichtung G verwendet werden. Das erste Aktivierungssignal EN1 muß nur entsprechend angepaßt werden, so daß eine Aktivierung und Deaktivierung ermöglicht wird.

Die Figuren 5a, 5b, 5c zeigen drei weitere Ausführungsbeispiele des Konfigurationssignal-Generators 1 ohne die erste Aktivierungseinrichtung G. Bei diesen Ausführungsbeispielen ist durch ein drittes Aktivierungssignal EN3, welches an das Gate eines Aktivierungstransistors T1 anlegbar ist, der Eingang IN1 des Konfigurationssignal-Generators 1 vom ersten Potential Vx trennbar. Diese Trennung sollte gleichzeitig zu seiner Inaktivierung durch das erste Aktivierungssignal EN1 erfolgen. Findet eine Aktivierung durch das erste EN1 und dritte EN3 Aktivierungssignal beim gleichen logischen Pegel statt, können die beiden Aktivierungsignale EN1, EN3 übereinstimmen.

Figur 5a zeigt zwischen dem Eingang IN1 und dem ersten Potential Vx in Serie zu dem Widerstandselement R den Aktivierungstransistor T1. Dieser ist vom p-Kanal-Typ.

In den Figuren 5b und 5c ist das Widerstandselement R durch zwei in Serie geschaltete Feldeffekttransistoren realisiert, deren Gates mit einem zweiten Potential VA verbunden sind. In Figur 5b sind die das Widerstandselement R bildenden beiden Feldeffekttransistoren und der Aktivierungstransistor T1 vom p-Kanal-Typ, in Figur 5c vom n-Kanal-Typ. Diese Ausführungsformen eignen sich besonders gut für eine nachträgliche Änderung eines Layouts, in dem das Widerstandselement R in Form einer Serienschaltung mehrerer Transistoren bereits enthalten ist. Dann kann durch lediglich kleine Änderungen des Layouts einer dieser Transistoren als Aktivierungstransistor T1 verwendet werden.

Die Ausführungsformen nach den Figuren 5a und 5b eignen sich für den Einsatz für erste Potentiale Vx, welche größer als die möglichen Potentiale am Eingang IN1 des Konfigurationssignal-Generators 1 sind. Die Ausführungsform nach Figur 5c eignet sich für solche, bei der das erste Potential Vx kleiner als die möglichen Potentiale am Eingang IN1 ist.

Durch das dritte Aktivierungssignal EN3 wird verhindert, daß zwischen der Kontaktierungsstelle 4 und dem ersten Potential Vx ein Strom fließt, wenn die Pufferschaltung 2 aktiv und der Konfigurationssignal-Generator 1 inaktiv ist. Somit wird erreicht, daß die Eingangssignale der Eingangspufferschaltung 2a bzw. die Ausgangssignale der Ausgangspufferschaltung 2b nicht beeinflußt werden. Ein Leckstrom von bzw. zum ersten Potential Vx wird vermieden und somit eine zusätzliche kapazitive Belastung der Kontaktierungsstelle 4 verhindert. Dies ist insbesondere für Eingangspufferschaltungen 2a entscheidend, da diese meist nur eine sehr geringe kapazitive Eingangslast aufweisen dürfen.

Figur 6 zeigt eine Ausführungsform einer Eingangspufferschaltung 2a. Sie weist einen CMOS-Inverter auf mit einem p-Kanal-Transistor T2 und einem n-Kanal-Transistor T3. Die Gates dieser beiden Transistoren sind miteinander verbunden und bilden den Eingang IN2a der Eingangspufferschaltung 2a. Die Source des n-Kanal-Transistors T3 ist mit einem niedrigen Versorgungspotential Masse der integrierten Schaltung verbunden. Die Drain des n-Kanal-Transistors T3 und des p-Kanal-Transistors T2 sind miteinander verbunden und bilden den Ausgang OUT2a der Eingangspufferschaltung 2a.

Die Eingangspufferschaltung 2a weist außerdem zweite Aktivierungseinrichtungen TEN1, TEN2 auf. Die Source des p-Kanal-Transistors T2 ist über einen ersten Enable-Transistor TEN1 vom p-Kanal-Typ mit einem hohen Versorgungspotential VY der integrierten Schaltung verbunden. Der Ausgang OUT2a der Eingangspufferschaltung 2a ist über einen zweiten Enable-Transistor TEN2 vom n-Kanal-Typ mit dem niedrigen Versorgungspotential Masse verbunden. Die Gates der beiden Enable-Transistoren TEN1, TEN2 sind mit dem zweiten Aktivierungssignal EN2 verbunden.

Wenn die Eingangspufferschaltung 2a über das zweite Aktivierungsignal EN2 ständig aktiviert sein darf (dies ist beispielsweise bei Clock-Eingängen der Fall), kann dieses gleich dem oder komplementär zum ersten Aktivierungsignal EN1 sein, welches gleichzeitig den Konfigurationssignal-Generator 1 inaktiv schalten muß. Soll die Eingangspufferschaltung 2a dagegen nur zeitweise aktiv sein, indem das zweite Aktivierungssignal EN2 sein Vorzeichen wechselt, müssen beide Aktivierungssignale unabhängig voneinander sein.

## Patentansprüche

1. Integrierte Schaltung, welche in zwei Varianten aus demselben Layout und mit denselben Masken herstellbar ist,
- mit einem Datenanschluß (5) und einem Versorgungspotentialanschluß (6) der integrierten Schaltung,
- mit einem Konfigurationssignal-Generator (1) mit einem Eingang (IN1),
- mit einer Pufferschaltung (2) mit einem Anschluß (A2),
- mit einer Kontaktierungsstelle (4), die mit dem Eingang (IN1) und dem Anschluß (A2) verbunden ist,
- entweder ist die integrierte Schaltung unter Nutzung der Pufferschaltung (2) betreibbar und die Kontaktierungsstelle (4) ist über einen Bonddraht (7) mit dem Datenanschluß (5) verbunden,
oder die integrierte Schaltung ist unter Nutzung des Konfigurationssignal-Generators (1) betreibbar und die Kontaktierungsstelle (4) ist mit keinem externen Anschluß der integrierten Schaltung oder über einen Bonddraht (7) mit dem Versorgungspotentialanschluß (6) verbunden.

2. Konfigurierbare integrierte Schaltung nach Anspruch 1,
**dadurch gekennzeichnet,**
daß der Konfigurationssignal-Generator (1) eine erste Aktivierungseinrichtung (G) aufweist, mittels derer er durch ein anlegbares erstes Aktivierungssignal (EN1) aktivierbar und deaktivierbar ist.

3. Konfigurierbare integrierte Schaltung nach einem der vorstehenden Ansprüche,
**dadurch gekennzeichnet,**
daß die Pufferschaltung (2) zweite Aktivierungseinrichtungen (TEN1, TEN2) aufweist, mittels derer sie durch ein anlegbares zweites Aktivierungssignal (EN2) aktivierbar und deaktivierbar ist.

4. Konfigurierbare integrierte Schaltung nach einem der vorstehenden Ansprüche,
**dadurch gekennzeichnet,**
daß die Pufferschaltung (2) eine Eingangspufferschaltung (2a) ist
und daß der Anschluß (A2) ihr Eingang (IN2a) ist.

5. Konfigurierbare integrierte Schaltung nach einem der Ansprüche 1 bis 3,
**dadurch gekennzeichnet,**
daß die Pufferschaltung (2) eine Ausgangspufferschaltung (2b) ist
und daß der Anschluß (A2) ihr Ausgang (OUT2b) ist.

6. Konfigurierbare integrierte Schaltung nach einem der vorstehenden Ansprüche,
**dadurch gekennzeichnet,**
daß der Eingang (IN1) des Konfigurationssignal-Generators (1) über ein Widerstandselement (R) mit einem ersten Potential (Vx), welches sich vom Versorgungspotential am Versorgungspotentialanschluß (6) unterscheidet, verbunden ist
und daß sein Eingang (IN1) mit seinem Ausgang (OUT1) verbunden ist.

7. Konfigurierbare integrierte Schaltung nach Anspruch 6,
**dadurch gekennzeichnet,**
daß zwischen dem Eingang (IN1) des Konfigurationssignal-Generators (1) und dem ersten Potential (Vx) außer dem Widerstandselement (R) in Serie zu diesem mindestens ein Aktivierungstransistor (T1) angeordnet ist, an dessen Gate ein drittes Aktivierungssignal (EN3) anlegbar ist.

8. Konfigurierbare integrierte Schaltung nach einem der Ansprüche 2 bis 7,
**dadurch gekennzeichnet,**
daß der Eingang (IN1) des Konfigurationssignal-Generators (1) über die erste Aktivierungseinrichtung (G) mit seinem Ausgang (OUT2) verbunden ist.

9. Konfigurierbare integrierte Schaltung nach Anspruch 8,
**dadurch gekennzeichnet,**
daß die erste Aktivierungseinrichtung (G) ein logisches Gatter ist
mit einem Eingang, der der Eingang (IN1) des Konfigurationssignal-Generators (1) ist,
mit einem weiteren Eingang, an dem das erste Aktivierungssignal (EN1) anlegbar ist,
und mit einem Ausgang, der der Ausgang (OUT1) des Konfigurationssignal-Generators (1) ist.

10. Konfigurierbare integrierte Schaltung nach Anspruch 9,
**dadurch gekennzeichnet,**
daß das logische Gatter ein NAND-Gatter ist.

11. Konfigurierbare integrierte Schaltung nach Anspruch 9,
**dadurch gekennzeichnet,**
daß das logische Gatter ein NOR-Gatter ist.

12. Konfigurierbare integrierte Schaltung nach einem der Ansprüche 7 bis 11,
**dadurch gekennzeichnet,**
daß das erste Aktivierungssignal (EN1) mit dem dritten Aktivierungssignal (EN3) übereinstimmt.

13. Konfigurierbare integrierte Schaltung nach einem der Ansprüche 3 bis 12,
**dadurch gekennzeichnet,**
daß das erste Aktivierungssignal (EN1) mit dem zweiten Aktivierungssignal (EN2) übereinstimmt.

14. Herstellungsverfahren für eine integrierte Schaltung, welche in zwei Varianten aus demselben Layout und mit denselben Masken herstellbar ist, mit einem Konfigurationssignal-Generator (1), einer Pufferschaltung (2), einer Kontaktierungsstelle (4), einem Datenanschluß (5) und einem Versorgungspotentialanschluß (6) der integrierten Schaltung mit folgenden Merkmalen:
- ein Eingang (IN1) des Konfigurationssignal-Generators (1) und ein Anschluß (A2) der Pufferschaltung (2) werden mit der Kontaktierungsstelle (4) verbunden,
- die Kontaktierungsstelle (4) wird
-- entweder mit dem Versorgungspotentialanschluß (6) über einen Bonddraht (7) oder mit keinem externen Anschluß der integrierten Schaltung verbunden, um die fertiggestellte integrierte Schaltung unter Nutzung des Konfigurationssignal-Generators (1) betreiben zu können,
-- oder über einen Bonddraht (7) mit dem Datenanschluß (5) verbunden, um die fertiggestellte integrierte Schaltung unter Nutzung der Pufferschaltung (2) betreiben zu können.

## Claims

1. Integrated circuit which can be produced in two variants from the same layout and with the same masks
- having a data connection (5) and a supply potential connection (6) of the integrated circuit,
- having a configuration signal generator (1) with an input (IN1),
- having a buffer circuit (2) with a connection (A2),
- having a contact-making point (4) which is connected to the input (IN1) and to the connection (A2),
- the integrated circuit can either be operated using the buffer circuit (2) and the contact-making point (4) is connected via a bonding wire (7) to the data connection (5),
or the integrated circuit can be operated using the configuration signal generator (1) and the contact-making point (4) is not connected to any external connection of the integrated circuit or is connected via a bonding wire (7) to the supply potential connection (6).

2. Configurable integrated circuit according to Claim 1, characterized in that the configuration signal generator (1) has a first activation device (G) by means of which it can be activated and deactivated by a first activation signal (EN1) which can be applied.

3. Configurable integrated circuit according to one of the preceding claims, characterized in that the buffer circuit (2) has second activation devices (TEN1, TEN2), by means of which it can be activated and deactivated by a second activation signal (EN2) which can be applied.

4. Configurable integrated circuit according to one of the preceding claims, characterized in that the buffer circuit (2) is an input buffer circuit (2a), and in that the connection (A2) is its input (IN2a).

5. Configurable integrated circuit according to one of Claims 1 to 3, characterized in that the buffer circuit (2) is an output buffer circuit (2b), and in that the connection (A2) is its output (OUT2b).

6. Configurable integrated circuit according to one of the preceding claims, characterized in that the input (IN1) of the configuration signal generator (1) is connected via a resistance element (R) to a first potential (Vx) which differs from the supply potential at the supply potential connection (6), and in that its input (IN1) is connected to its output (OUT1).

7. Configurable integrated circuit according to Claim 6, characterized in that, apart from the resistance element (R), at least one activation transistor (T1) is arranged in series with said resistance element (R) between the input (IN1) of the configuration signal generator (1) and the first potential (Vx), to the gate of which activation transistor (T1) a third activation signal (EN3) can be applied.

8. Configurable integrated circuit according to one of Claims 2 to 7, characterized in that the input (IN1) of the configuration signal generator (1) is connected to its output (OUT2) via the first activation device (G).

9. Configurable integrated circuit according to Claim 8, characterized in that the first activation device (G) is a logic gate having an input which is the input (IN1) of the configuration signal generator (1), having a further input to which the first activation signal (EN1) can be applied, and having an output which is the output (OUT1) of the configuration signal generator (1).

10. Configurable integrated circuit according to Claim 9, characterized in that the logic gate is a NAND gate.

11. Configurable integrated circuit according to Claim 9, characterized in that the logic gate is a NOR gate.

12. Configurable integrated circuit according to one of Claims 7 to 11, characterized in that the first activation signal (EN1) corresponds with the third activation signal (EN3).

13. Configurable integrated circuit according to one of Claims 3 to 12, characterized in that the first activation signal (EN1) corresponds with the second activation signal (EN2).

14. Production method for an integrated circuit which can be produced in two variants from the same layout and with the same masks having a configuration signal generator (1), a buffer circuit (2), a contact-making point (4), a data connection (5) and a supply potential connection (6) on the integrated circuit, having the following features:
- an input (IN1) of the configuration signal generator (1) and a connection (A2) of the buffer circuit (2) are connected to the contact-making point (4),
- the contact-making point (4) is
-- either connected to the supply potential connection (6) via a bonding wire (7) or is not connected to any external connection of the integrated circuit, in order to allow the complete integrated circuit to be operated using the configuration signal generator (1),
-- or is connected via a bonding wire (7) to the data connection (5), in order to allow the complete integrated circuit to be operated using the buffer circuit (2).

## Revendications

1. Circuit intégré, qui peut être fabriqué en deux variantes à partir du même layout et avec les mêmes masques,
- comportant une borne de données (5) et une borne de potentiel d'alimentation (6) du circuit intégré,
- un générateur de signal de configuration (1) comportant une entrée (IN1),
- un circuit tampon (2) comportant une borne (A2),
- un point de contact (4) qui est relié à l'entrée (IN1) et à la borne (A2),
- soit le circuit intégré peut fonctionner en exploitant le circuit tampon (2) et le point de contact (4) est relié par l'intermédiaire d'un fil de soudure (7) à la borne de données (5),
soit le circuit intégré peut fonctionner en exploitant le générateur de signal de configuration (1) et le point de contact (4) n'est relié à aucune borne externe du circuit intégré ou est relié par l'intermédiaire d'un fil de soudure (7) à la borne de potentiel d'alimentation (6).

2. Circuit intégré configurable selon la revendication 1,
**caractérisé par le fait que**
le générateur de signal de configuration (1) comporte un premier dispositif d'activation (G) au moyen duquel il peut être activé ou désactivé par un premier signal d'activation (EN1) pouvant être appliqué.

3. Circuit intégré configurable selon l'une des revendications précédentes,
**caractérisé par le fait que**
le circuit tampon (2) comporte des seconds dispositifs d'activation (TEN1, TEN2) au moyen desquels il peut être activé et désactivé par un second signal d'activation (EN2) pouvant être appliqué.

4. Circuit intégré configurable selon l'une des revendications précédentes,
**caractérisé par le fait que**
le circuit tampon (2) est un circuit tampon d'entrée (2a)
et la borne (A2) est son entrée (IN2a).

5. Circuit intégré configurable selon l'une des revendications 1 à 3,
**caractérisé par le fait que**
le circuit tampon (2) est un circuit tampon de sortie (2b)
et la borne (A2) est sa sortie (OUT2b).

6. Circuit intégré configurable selon l'une des revendications précédentes,
**caractérisé par le fait que**
l'entrée (IN1) du générateur de signal de configuration (1) est reliée par l'intermédiaire d'un élément formant résistance (R) à un premier potentiel (Vx) qui est différent du potentiel d'alimentation présent à la borne de potentiel d'alimentation (6),
et son entrée (IN1) est reliée à sa sortie (OUT1).

7. Circuit intégré configurable selon la revendication 6,
**caractérisé par le fait que**
au moins un transistor d'activation (T1), à la grille duquel peut être appliqué un troisième signal d'activation (EN3), est placé entre l'entrée (IN1) du générateur de signal de configuration (1) et le premier potentiel (Vx), en plus de l'élément formant résistance (R) et en série avec ce dernier.

8. Circuit intégré configurable selon l'une des revendications 2 à 7,
**caractérisé par le fait que**
l'entrée (IN1) du générateur de signal de configuration (1) est reliée par l'intermédiaire du premier dispositif d'activation (G) à sa sortie (OUT2).

9. Circuit intégré configurable selon la revendication 8,
**caractérisé par le fait que**
le premier dispositif d'activation (G) est une porte logique,
comportant une entrée qui est l'entrée (IN1) du générateur de signal de configuration (1),
une autre entrée à laquelle peut être appliqué le premier signal d'activation (EN1),
et une sortie qui est la sortie (OUT1) du générateur de signal de configuration (1).

10. Circuit intégré configurable selon la revendication 9,
**caractérisé par le fait que**
la porte logique est une porte NON-ET.

11. Circuit intégré configurable selon la revendication 9,
**caractérisé par le fait que**
la porte logique est une porte NON-OU.

12. Circuit intégré configurable selon l'une des revendications 7 à 11,
**caractérisé par le fait que**
le premier signal d'activation (EN1) coïncide avec le troisième signal d'activation (EN3).

13. Circuit intégré configurable selon l'une des revendications 3 à 12,
**caractérisé par le fait que**
le premier signal d'activation (EN1) coïncide avec le second signal d'activation (EN2).

14. Procédé de fabrication d'un circuit intégré, qui peut être fabriqué en deux variantes à partir du même layout et avec les mêmes masques, comportant un générateur de signal de configuration (1), un circuit tampon (2), un point de contact (4), une borne de données (5) et une borne de potentiel d'alimentation (6) du circuit intégré, ayant les caractéristiques suivantes :
- on relie une entrée (IN1) du générateur de signal de configuration (1) et une borne (A2) du circuit tampon (2) au point de contact (4), et
- on relie le point de contact (4)
-- soit à la borne de potentiel d'alimentation (6) par l'intermédiaire d'un fil de soudure (7) ou à aucune borne externe du circuit intégré, afin de pouvoir faire fonctionner le circuit intégré terminé en exploitant le générateur de signal de configuration (1),
-- soit à la borne de données (5) par l'intermédiaire d'un fil de soudure (7), afin de pouvoir faire fonctionner le circuit intégré terminé en exploitant le circuit tampon (2).
